(19)

**Europäisches Patentamt**
**European Patent Office**
**Office européen des brevets**

(11) **EP 4 415 198 B1**

(12) **EUROPEAN PATENT SPECIFICATION**

(45) Date of publication and mention
of the grant of the patent:
**23.07.2025 Bulletin 2025/30**

(21) Application number: **24152761.3**

(22) Date of filing: **19.01.2024**

(51) International Patent Classification (IPC):
*H02J 1/10* (2006.01)    *H02J 7/00* (2006.01)

(52) Cooperative Patent Classification (CPC):
**H02J 7/0013; H02J 1/10; H02J 7/0016;**
**H02J 7/0063; H02J 7/00712;** Y02E 60/10

(54) **BATTERY CLUSTER TOPOLOGY AND CONTROL METHOD OF BATTERY CLUSTER FOR LITHIUM-ION BATTERY ENERGY STORAGE SYSTEM**

BATTERIECLUSTERTOPOLOGIE UND STEUERUNGSVERFAHREN FÜR BATTERIECLUSTER FÜR EIN LITHIUM-IONEN-BATTERIEENERGIESPEICHERSYSTEM

TOPOLOGIE DE GROUPE DE BATTERIES ET PROCÉDÉ DE COMMANDE DE GROUPE DE BATTERIES POUR SYSTÈME DE STOCKAGE D'ÉNERGIE DE BATTERIE AU LITHIUM-ION

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **12.02.2023 CN 202310100433**

(43) Date of publication of application:
**14.08.2024 Bulletin 2024/33**

(73) Proprietor: **Vilion (Shenzhen) New Energy Technology Co., Ltd.**
**Shenzhen, Guangdong 518118 (CN)**

(72) Inventors:
• **SONG, Shawn**
**Shenzhen 518118 (CN)**
• **ZHANG, Dias**
**Shenzhen 518118 (CN)**
• **TAN, Ivan**
**Shenzhen 518118 (CN)**

(74) Representative: **Zaboliene, Reda**
**Metida**
**Business center Vertas**
**Gyneju str. 16**
**01109 Vilnius (LT)**

(56) References cited:
**US-A1- 2016 075 254     US-A1- 2020 136 412**
**US-A1- 2020 177 018     US-A1- 2022 224 129**
**US-B2- 10 449 869**

**Description**

**Technical field**

The present invention relates to technical field of a lithium-ion battery energy storage system, in particular to a battery cluster topology and a control method of battery cluster suitable for a lithium-ion battery energy storage system.

**Brief Description of the Related Art**

On September 22, 2020, the Chinese government proposed a goal at the 75th United Nations General Assembly that China will increase its nationally determined contributions, adopt more powerful policies and measures, strive to peak carbon dioxide emissions before 2030, and strive to achieve carbon neutrality before 2060. Energy storage technology is one of the key technologies to achieve this goal, and lithium-ion battery energy storage technology has attracted much attention as the most widely used electrochemical energy storage technology. At the same time, our country has become the world's largest new energy vehicle market. After 2020, a large number of lithium-ion power batteries in our country will gradually begin to be retired. There are currently two main processing paths for these retired batteries. One is for those that are not scrapped but have reduced capacity and cannot be used in electric vehicles, to be utilized step by step to allow them to use their waste heat in other areas (such as power storage); and the other one is to dismantle scrapped power batteries and recycle valuable materials.

With reference to whether retired batteries or new batteries, there are performance inconsistencies due to health status, internal resistance, self-discharge and other factors. However, large and medium-sized lithium-ion battery energy storage systems generally consist of multiple battery clusters connected in series or parallel or a mixed connection thereof. The battery cluster is composed of multiple battery packs connected in series, parallel, or a mixed connection thereof, while the battery pack is composed of multiple single cells connected in series, parallel, or a mixed connection thereof. The performance inconsistency of the single battery will inevitably lead to inconsistency in battery packs and battery clusters, thereby affecting the performance of battery packs and battery clusters. In serious cases, it may lead to safety accidents.

In the application of maintenance and replacement of old and new batteries, and the replacement of lead-acid batteries by lithium-ion batteries, due to the inconsistency in battery types and performance status, the existing solution must replace the entire battery cluster or the entire battery pack, which is a big waste of battery resources and increases the cost.

Further, US patent publication US2020/0177018A1 discloses a control device of a power supply system which is configured to control inputting of electric power from a power system connected to a power distribution device to a plurality of strings connected to the power distribution device and outputting of electric power from the plurality of strings to the power system and to execute a process of stopping control for switching the at least one switching element between connection and disconnection on a string in which inputting of electric power and outputting of electric power are stopped out of the plurality of strings.

In parallel applications of multiple battery clusters, when the battery types and performance status between battery clusters are inconsistent, it will cause inrush current and return current between battery clusters. In severe cases, it will lead to battery overcharge, over-discharge and other safety issues. This should be avoided in energy storage system integration.

Therefore, it seems very necessary how to reduce the component cost or maintenance and replacement cost of the lithium-ion battery energy storage system, improve system efficiency, and improve safety and reliability, from the comprehensive dimensions of the topology, the control method, and control strategy of the lithium-ion battery energy storage system.

**Summary of the Disclosure**

The technical problem to be solved by the present invention is to overcome the above-mentioned defects of the prior art and provide a battery cluster topology and a control method of battery cluster suitable for a lithium-ion battery energy storage system.

The present invention is achieved by the following defined in the independent claims and the preferred embodiments defined in the dependent claims.

A battery cluster topology for a lithium-ion battery energy storage system, the battery cluster topology for the lithium-ion battery energy storage system comprises P parallel battery cluster units (P is a natural number greater than or equal to 2), each battery cluster unit is composed of N battery packs (N is a natural number greater than or equal to 2), N bidirectional DC/DC voltage conversion modules, N bypass switches, BDCM coordination controller units, circuit switches and primary buses for connection.

Output ends of the N bidirectional DC/DC voltage conversion modules are connected in series in sequence, a negative output end of the first bidirectional DC/DC voltage conversion module is connected with a negative electrode of the primary bus, and a positive output end of the first bidirectional DC/DC voltage conversion module is connected with a negative output end of the second bidirectional DC/DC voltage conversion module, a positive output end of the second bidirectional DC/DC voltage conversion module is connected with a negative output end of the third bidirectional DC/DC voltage conversion module, and a positive output end of $(N-1)^{th}$ bidirectional DC/DC voltage conversion module is connected with a negative output end of the $N^{th}$ bidirectional DC/DC voltage conversion module, and a negative output end of the $N^{th}$ bidirectional DC/DC voltage conversion module is connected with one end of the circuit switch, and the other end of the circuit switch is connected with a positive electrode of the primary bus.

The N battery packs are connected in parallel with input ends of the N bidirectional DC/DC voltage conversion modules, a positive end of the first battery pack is connected with a positive input end of the first bidirectional DC/DC voltage conversion module, and a negative end of the first battery pack is connected with a negative input end of the first bidirectional DC/DC voltage conversion module, a positive end of the $N^{th}$ battery pack is connected with a positive input end of the $N^{th}$ bidirectional DC/DC voltage conversion module, and a negative end of the $N^{th}$ battery pack is connected with a negative input end of the $N^{th}$ bidirectional DC/DC voltage conversion module.

The N bypass switches are connected in parallel with output ends of the N bidirectional DC/DC voltage conversion modules, one end of the first bypass switch is connected with the negative output end of the first bidirectional DC/DC voltage conversion module, the other end of the first bypass switch is connected with the positive output end of the first bidirectional DC/DC voltage conversion module, one end of the $N^{th}$ bypass switch is connected with the negative output end of the $N^{th}$ bidirectional DC/DC voltage conversion module, and the other end of the $N^{th}$ bypass switch is connected with the positive output end of the $N^{th}$ bidirectional DC/DC voltage conversion module.

The bidirectional DC/DC voltage conversion module integrates functions of the battery management unit BMU, which can calculate a state of charge, estimate a health status, and manage safety of the battery pack for the battery pack, and the bidirectional DC/DC voltage conversion modules regulate its output voltage according to instructions of the BDCM coordination controller units.

The bypass switches function as the bypass bidirectional DC/DC voltage conversion modules.

The BDCM coordination controller units manage the battery cluster, having functions of charging and discharging management of the battery cluster, calculation of the state of charge of the battery cluster, safety management of the battery cluster, controlling the bypass switches to close or open, and controlling the circuit switches to close or open, and having a function of communicating and information interaction with the outside.

The battery pack consists of two or more single lithium-ion batteries connected in series.

The BDCM coordination controller unit is connected with the bidirectional DC/DC voltage conversion module, the bypass switch, and the circuit switch through the communication bus, and the battery management unit BMU of the bidirectional DC/DC voltage conversion module is communicatively connected with an underlying management unit of the battery pack.

The control method of battery cluster includes calculating the total target voltage of the battery cluster, starting a process control, and stopping the process control.

The step of calculating the total target voltage of battery cluster in the control method of battery cluster is as follows:

Step 1, the $n^{th}$ BDCM coordination controller unit reads current voltages of all N battery packs in the $n^{th}$ battery cluster unit, and adds voltages of the N battery pack to obtain the total voltage V_total_n of the $n^{th}$ battery cluster unit, n being a natural number from 1 to P.

Step 2, each BDCM coordination controller unit broadcasts the total voltage of a corresponding battery cluster unit on its communication bus, each BDCM coordination controller unit compares the total voltage of the battery cluster unit of this battery cluster unit with those of the battery cluster units among other battery cluster units, and each BDCM coordination controller unit broadcasts the maximum value of total voltage of the battery cluster in the battery cluster unit determined by itself on its communication bus.

Step 3, each BDCM coordination controller unit receives the maximum value of the total voltage of the battery cluster broadcast on the communication bus, and compares these results with the maximum value of the total voltage of the battery cluster determined by itself, if the results are different, then it returns to the step 1 and calculates again; or if the results are the same, then it calculates the total target voltage of the battery cluster, the total target voltage of $n^{th}$ battery cluster is V_target_cluster_n, V_target_cluster_n=V_max_cluster+V_con, where the V_max_cluster is the maximum value of the total voltage of the battery clusters in all P battery cluster units, n is a natural number from 1 to P, V_con is a fixed limit value, and the value of V_con satisfies: V_con$\leq$V_DC_sum- V_max_cluster, where V_DC_sum is a sum of the limit values of the output voltages of all bidirectional DC/DC voltage conversion modules in the battery cluster which has a maximum value of the total voltage of the battery cluster.

The step of starting process control in the control method of battery cluster is as follows:

Step 1, the $n^{th}$ BDCM coordination controller unit reads the information of the battery pack and the bidirectional DC/DC voltage conversion module of the $n^{th}$ battery cluster unit, including the state of charge of the battery pack, the voltage of the battery pack, temperature of the battery pack, and fault information of the bidirectional DC/DC voltage conversion module.

Step 2, the $n^{th}$ BDCM coordination controller unit determines consistency of the status of all N battery packs in the $n^{th}$ battery cluster unit.

Step 3, if the consistency of the battery pack status of the $n^{th}$ battery cluster unit meets requirements, the $n^{th}$ BDCM coordination controller unit broadcasts the output voltage V_out_n of all bidirectional DC/DC voltage conversion modules of the $n^{th}$ battery cluster on the communication bus, and V_out_n=V_target_cluster_n/m, m is the number of all fault-free battery packs in the $n^{th}$ battery cluster; if the consistency of the battery pack status of the $n^{th}$ battery cluster unit does not meet the requirements, then the $k^{th}$ bidirectional DC/DC voltage conversion module of the $n^{th}$ battery cluster has a discharge output voltage $V\_dis\_out\_nk=V\_target\_cluster\_n\times SOC_{nk}/\sum_{i=1}^{m} SOC_{ni}$, the $k^{th}$ bidirectional DC/DC voltage conversion module of the $n^{th}$ battery cluster has a charging output voltage

$$V\_ch\_out\_nk=V\_target\_cluster\_n\times (1\text{-}SOC_{nk}) \div (m - \sum_{i=1}^{m} SOC_{ni})$$, where $SOC_{nk}$ is the charge ratio of the $k^{th}$ battery pack of the $n^{th}$ battery cluster, and m is the number of all fault-free battery packs of the $n^{th}$ battery cluster, $\sum_{i=1}^{m} SOC_{ni}$ represents the sum of the charge ratios of all m fault-free battery packs in the $n^{th}$ battery cluster, obviously, $m \leq P$.

Step 4, if the output voltage of b bidirectional DC/DC voltage conversion modules in the $n^{th}$ battery cluster exceeds the limit value (assuming the limit value is V_out_limit), the $n^{th}$ BDCM coordination controller unit controls the output voltage of the bidirectional DC/DC voltage conversion module to be V_out_limit, all other bidirectional DC/DC voltage conversion modules in the $n^{th}$ battery cluster have an output voltage V_out_n=(V_target_cluster_n-V_out_limit)÷(m-b), where m is the number of all fault-free battery packs in the $n^{th}$ battery cluster, and b is a natural number from 1 to m.

Step 5, the $n^{th}$ BDCM coordination controller unit determines whether the total voltage of the $n^{th}$ battery cluster unit reaches the total target voltage V_target_cluster_n of the $n^{th}$ battery cluster or not, if not, it returns to the step 1, if it does, it proceeds to the charging or discharging phase. In the above steps 1 to 5, n is a natural number from 1 to P, and P is the number of battery clusters.

The step of stopping the process control in the control method of battery cluster is as follows:

Step 1, if the $n^{th}$ BDCM coordination controller unit detects that the $r^{th}$ battery pack of the $n^{th}$ battery cluster unit fails, or the $r^{th}$ battery pack reaches the charge cut-off condition, or the $r^{th}$ battery pack reaches the discharge cut-off condition, or the $r^{th}$ bidirectional DC/DC voltage conversion module fails, it proceeds to the next step.

Step 2, the $n^{th}$ BDCM coordination controller unit controls the output voltage of the $r^{th}$ bidirectional DC/DC voltage conversion module of the $n^{th}$ battery cluster unit to be zero.

Step 3, the $n^{th}$ BDCM coordination controller unit controls the bypass switch in the $n^{th}$ battery cluster unit that is connected in parallel with the $r^{th}$ bidirectional DC/DC voltage conversion module to close.

Step 4: the $n^{th}$ BDCM coordination controller unit controls the $r^{th}$ bidirectional DC/DC voltage conversion modules of the $n^{th}$ battery cluster unit to turn off the output.

Step 5, the method returns to the step of calculating the total target voltage of the battery cluster, and then performs the step of starting the process control; if the total voltage of the battery cluster unit does not reach the total target voltage of the battery cluster, or the battery cluster unit has overcurrent protection, then the battery cluster unit stops operating.

Compared with the prior art, the battery topology and the control method of battery cluster for the lithium-ion battery energy storage system of the present invention have the following advantages.

(1) It is beneficial to give full play to the performance of the battery pack. Because in each battery cluster of the present invention, each battery pack is connected in parallel with the input end of one bidirectional DC/DC voltage conversion module, and then connected in series through the output end of the bidirectional DC/DC voltage conversion module; and the output end of each bidirectional DC/DC voltage conversion module is also connected in parallel with a bypass switch. This topology combined with the control method of battery cluster of the present disclosure, can realize dynamic management and control of each battery pack, and actively adjust the charging and discharging of the battery pack according to the performance of the battery pack, so that the performance of the battery pack can be fully exerted, more advantageous especially for battery packs with poor consistency, which are utilized step by step.

(2) It is helpful to improve the safety of the lithium-ion battery energy storage system. Before charging and discharging in parallel, each battery cluster unit of the present invention first goes through the calculation of the total target voltage of the battery cluster and the starting process control process. The total voltage of each battery cluster all reaches a state with very small deviation, so it can to a very large extent reduce bias current and circulating current phenomenon during parallel charging and discharging of battery clusters, thereby improving safety. At the same time, during the operation of the energy storage system, if the battery pack or the bidirectional DC/DC voltage conversion module in any battery cluster fails or reaches protection conditions, it can promptly stop the operation of the bidirectional DC/DC voltage conversion module and the battery pack by the means of closing the bypass switches that can be connected in parallel with the output end of the bidirectional DC/DC voltage conversion module, which is very beneficial to improve safety.

**Brief Description of the Drawings:**

FIG. 1 is a schematic diagram of circuit connection of a battery cluster unit according to an embodiment of the present invention.
FIG. 2 is a topology diagram of parallel connection of battery clusters according to an embodiment of the present invention.

**Detailed Description of Specific Embodiment**

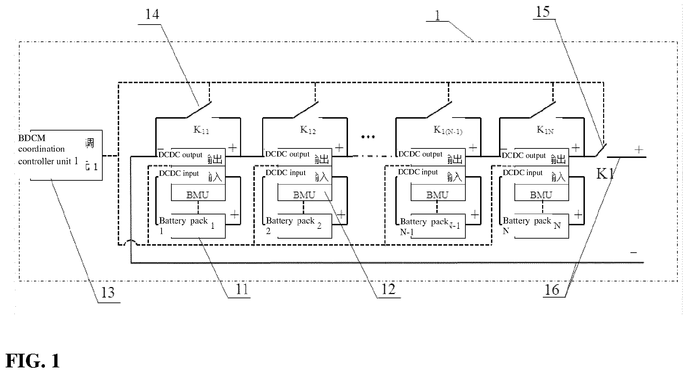

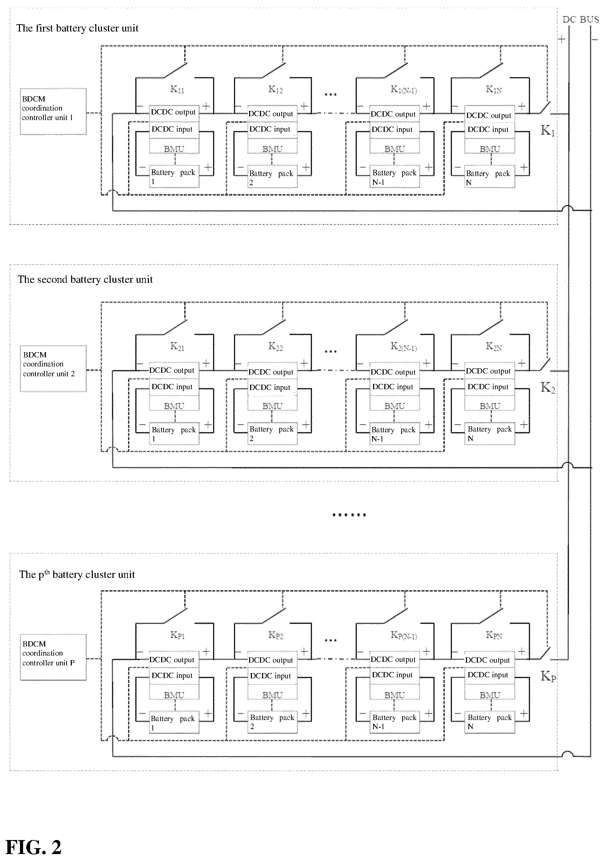

The specific embodiments of the present invention will be further described in detail below with reference to the accompanying drawings.
According to an embodiment of the present invention, a battery cluster topology and a control method of battery cluster for a lithium-ion battery energy storage system are provided. As shown in FIGS. 1 and 2, the battery cluster topology for the lithium-ion battery energy storage system includes P (P is a natural number greater than or equal to 2) battery cluster units 1 connected in parallel. Each battery cluster unit 1 is composed of N (N is a natural number greater than or equal to 2) battery packs 11, N bidirectional DC/DC voltage conversion modules 12, a BDCM coordination controller unit 13, N bypass switches 14, circuit switches 15, and a primary bus 16 for connection.
As shown in FIG. 1, output ends of the bidirectional DC/DC voltage conversion modules 12 are connected in series. A negative output end of the first bidirectional DC/DC voltage conversion module is connected with a negative electrode of the primary bus. A positive output end of the first bidirectional DC/DC voltage conversion module is connected with a negative output end of a second bidirectional DC/DC voltage conversion module, and a positive output end of the second bidirectional DC/DC voltage conversion module is connected with a negative output end of the third bidirectional DC/DC voltage conversion module. A positive output end of the $(N-1)^{th}$ bidirectional DC/DC voltage conversion module is connected with a negative output end of a $N^{th}$ bidirectional DC/DC voltage conversion module, and a negative output end of the $N^{th}$ bidirectional DC/DC voltage conversion module is connected with one end of the circuit switch, and the other end of the circuit switch is connected with a positive electrode of the primary bus.
The N battery packs are connected in parallel with input ends of the N bidirectional DC/DC voltage conversion modules, a positive end of the first battery pack is connected with a positive input end of the first bidirectional DC/DC voltage conversion module, and a negative end of a first battery pack is connected with a negative input end of the first bidirectional DC/DC voltage conversion module, a positive end of the $N^{th}$ battery pack is connected with a positive input end of the $N^{th}$ bidirectional DC/DC voltage conversion module, and a negative end of the $N^{th}$ battery pack is connected with a negative input end of the $N^{th}$ bidirectional DC/DC voltage conversion module.
The N bypass switches are connected in parallel with output ends of the N bidirectional DC/DC voltage conversion modules. One end of the first bypass switch is connected with a negative output end of the first bidirectional DC/DC voltage conversion module. The other end of the first bypass switch is connected with a positive output end of the first bidirectional DC/DC voltage conversion module, one end of the $N^{th}$ bypass switch is connected with a negative output end of the $N^{th}$ bidirectional DC/DC voltage conversion module, and the other end of $N^{th}$ bypass switch is connected with a positive output end of the $N^{th}$ bidirectional DC/DC voltage conversion module.
The bidirectional DC/DC voltage conversion module integrates the functions of the battery management unit BMU. The BMU can calculate the state of charge, estimate the health status, and manage the battery pack safety for the battery pack. The bidirectional DC/DC voltage conversion module regulates its output voltage according to instructions of the BDCM coordination controller unit.
The bypass switch functions as a bypass bidirectional DC/DC voltage conversion module.
The BDCM coordination controller unit manages the battery cluster, including the functions like charging and discharging management of the battery cluster, calculation of the state of charge of the battery cluster, safety management of the battery cluster, controlling the bypass switch to close or open, and controlling the circuit switch to close or open; and has the function of communicating and information interaction with the outside.

In an embodiment of the present disclosure, the battery pack is composed of more than two single lithium-ion batteries connected in series, and the battery pack is integrated with an underlying management unit for voltage sampling, temperature sampling, and balancing purposes.

The BDCM coordination controller unit is connected with the bidirectional DC/DC voltage conversion module, the bypass switches, and the circuit switches through a communication bus. The battery management unit BMU of the bidirectional DC/DC voltage conversion module is communicatively connected with the underlying management unit of the battery pack.

A control method of battery cluster includes calculating a total target voltage of battery cluster, starting a process control, and stopping the process control.

The step of calculating the total target voltage of the battery cluster in the control method of battery cluster is as follows.

Step 1, the $n^{th}$ BDCM coordination controller unit reads current voltages of all N battery packs in the $n^{th}$ battery cluster unit, and adds voltages of the N battery pack to obtain the total voltage V_total_n of the $n^{th}$ battery cluster unit, and n is a natural number from 1 to P.

Step 2, each BDCM coordination controller unit broadcasts the total voltage of the corresponding battery cluster unit on its communication bus. Each BDCM coordination controller unit compares the total voltage of the battery cluster unit of this battery cluster unit with those of the battery cluster units among other battery cluster units. Each BDCM coordination controller unit broadcasts the maximum value of the total voltage of the battery cluster in the battery cluster unit determined by itself on its communication bus.

Step 3, each BDCM coordination controller unit receives the maximum value of the total voltage of the battery cluster broadcast on the communication bus, and compares these results with the maximum value of the total voltage of the battery cluster determined by itself. If the results are different, then it returns to the step 1 and calculates again. If the results are the same, then it calculates the total target voltage of the battery cluster, the total target voltage of $n^{th}$ battery cluster is V_target_cluster_n, V_target_cluster_n=V_max_cluster+a fixed limit value, where the V_max_cluster is the maximum total voltage of the battery clusters in all P battery cluster units, the fixed limit value is an allowable deviation of the total voltage of P battery clusters, and n is a natural number from 1 to P.

The step of starting the process control in the control method of the battery cluster is as follows.

Step 1, the $n^{th}$ BDCM coordination controller unit reads the information of the battery pack and the bidirectional DC/DC voltage conversion module of the $n^{th}$ battery cluster unit, including the state of charge of the battery pack, the voltage of the battery pack, temperature of the battery pack, and fault information of the bidirectional DC/DC voltage conversion module.

Step 2, the $n^{th}$ BDCM coordination controller unit determines the consistency of the status of all N battery packs in the $n^{th}$ battery cluster unit.

Step 3, if the consistency of the battery pack status of the $n^{th}$ battery cluster unit meets the requirements, the $n^{th}$ BDCM coordination controller unit broadcasts the output voltage V_out_n of all bidirectional DC/DC voltage conversion modules of the $n^{th}$ battery cluster on the communication bus, and V_out_n=V_target_cluster_n/the number of all fault-free battery packs in the $n^{th}$ battery cluster; if the consistency of the battery pack status of the $n^{th}$ battery cluster unit does not meet the requirements, then the $k^{th}$ bidirectional DC/DC voltage conversion module of the $n^{th}$ battery cluster has a

$$V\_dis\_out\_nk=V\_target\_cluster\_n \times SOC_{nk}/\sum_{i=1}^{m} SOC_{ni}$$

discharge output voltage , the $k^{th}$ bidirectional DC/DC voltage conversion module of the $n^{th}$ battery cluster has a charging output voltage

$$V\_ch\_out\_nk=V\_target\_cluster\_n \times (1\text{-}SOC_{nk})/(m-\sum_{i=1}^{m} SOC_{ni})$$

, where $SOC_{nk}$ is the charge ratio of the $k^{th}$ battery pack of the $n^{th}$ battery cluster, and m is the number of all fault-free battery packs of the $n^{th}$ battery cluster, and $\sum_{i=1}^{m} SOC_{ni}$ represents the sum of the charge ratios of all m fault-free battery packs in the $n^{th}$ battery cluster, obviously, m $\leq$ P.

Step 4, if the output voltage of one of the bidirectional DC/DC voltage conversion modules in the $n^{th}$ battery cluster exceeds the limit value (assuming the limit value is V_out_limit), the $n^{th}$ BDCM coordination controller unit controls the output voltage of the bidirectional DC/DC voltage conversion module to be V_out_limit. All other bidirectional DC/DC voltage conversion modules in the $n^{th}$ battery cluster have an output voltage V_out_n=(V_target_cluster_n-V_out_limit)/(the number of all fault-free battery packs in the $n^{th}$ battery cluster -(subtract)1).

Step 5, the $n^{th}$ BDCM coordination controller unit determines whether the total voltage of the $n^{th}$ battery cluster unit reaches the total target voltage V_target_cluster_n of the $n^{th}$ battery cluster or not. If not, it returns to the step 1. If it does, it proceeds to the charging or discharging phase. In the above steps 1 to 5, n is a natural number from 1 to P, and P is the number of battery clusters.

The step of stopping the process control in the control method of battery clusters is as follows.

Step 1, if the $n^{th}$ BDCM coordination controller unit detects that the $r^{th}$ battery pack of the $n^{th}$ battery cluster unit fails, or the $r^{th}$ battery pack reaches the charge cut-off condition, or the $r^{th}$ battery pack reaches the discharge cut-off condition, or the $r^{th}$ bidirectional DC/DC voltage conversion module fails, it proceeds to the next step.

Step 2, the $n^{th}$ BDCM coordination controller unit controls the output voltage of the $r^{th}$ bidirectional DC/DC voltage conversion module of the $n^{th}$ battery cluster unit to be zero.

Step 3, the $n^{th}$ BDCM coordination controller unit controls the bypass switch in the $n^{th}$ battery cluster unit that is connected in parallel with the $r^{th}$ bidirectional DC/DC voltage conversion module to close.

Step 4: the $n^{th}$ BDCM coordination controller unit controls the $r^{th}$ bidirectional DC/DC voltage conversion modules of the $n^{th}$ battery cluster unit to turn off the output.

Step 5, the method returns to the step of calculating the total target voltage of the battery cluster, and then performs the step of starting the process control; if the total voltage of the battery cluster unit does not reach the total target voltage of the battery cluster, or the battery cluster unit has overcurrent protection, then the battery cluster unit stops operating.

The present invention is advantageous to give full play of the performance of the battery packs. In each battery cluster of the present invention, each battery pack is connected in parallel with the input end of a bidirectional DC/DC voltage conversion module, and then connected in series through the output end of the bidirectional DC/DC voltage conversion module; and the output end of each bidirectional DC/DC voltage conversion module is also connected in parallel with a bypass switch. This topology combined with the control method of the battery clusters of the present disclosure, can realize dynamic management and control of each battery pack, and actively adjust the charging and discharging of the battery pack according to the performance of the battery pack, so that the performance of the battery pack can be fully exerted, being more advantageous especially for battery packs with poor consistency, which are used step by step.

In each battery cluster of the present invention, each battery pack is connected in parallel with the input end of a bidirectional DC/DC voltage conversion module, and then connected in series through the output end of the bidirectional DC/DC voltage conversion module; and the output end of each bidirectional DC/DC voltage conversion module is also connected in parallel with a bypass switch. This topology combined with the control method of the battery clusters of the present disclosure, can realize dynamic management and control of each battery pack, and actively adjust the charging and discharging of the battery pack according to the performance of the battery pack, so that the performance of the battery pack can be fully exerted, being more advantageous especially for battery packs with poor consistency, which are used step by step.

Before charging and discharging in parallel, each battery cluster unit of the present invention first goes through the calculation of the total target voltage of the battery cluster and the starting process control process. The total voltage of each battery cluster all reaches a state with very small deviation, so it can reduce to a very large extent bias current and circulating current phenomenon during parallel charging and discharging of battery clusters, thereby improving safety. At the same time, during the operation of the energy storage system, if the battery pack or the bidirectional DC/DC voltage conversion module in any battery cluster fails or reaches protection conditions, it can promptly stop the operation of the bidirectional DC/DC voltage conversion module and the battery pack by the means of closing the bypass switches that can be connected in parallel with the output end of the bidirectional DC/DC voltage conversion module, which is very beneficial to improve safety.

## Claims

1. A control method of battery cluster for a lithium-ion battery energy storage system ,

    wherein a battery cluster topology for the lithium-ion battery energy storage system comprises P parallel battery cluster units, where each battery cluster unit (1) is composed of N battery packs (11) , N bidirectional DC/DC voltage conversion modules (12), N bypass switches (14), BDCM coordination controller units (13), circuit switches (15), primary buses (16) for connection, where P is a natural number greater than or equal to 2, N is a natural number greater than or equal to 2;
    output ends of the N bidirectional DC/DC voltage conversion modules (12) are connected in series in sequence, a negative output end of the first bidirectional DC/DC voltage conversion module (12) is connected with a negative electrode of the primary bus (16), and a positive output end of the first bidirectional DC/DC voltage conversion module (12) is connected with a negative output end of the second bidirectional DC/DC voltage conversion module (12), a positive output end of the second bidirectional DC/DC voltage conversion module (12) is connected with a negative output end of the third bidirectional DC/DC voltage conversion module(12), and a positive output end of (N-1)$^{th}$ bidirectional DC/DC voltage conversion module (12) is connected with a negative output end of the N$^{th}$ bidirectional DC/DC voltage conversion module (12), and a negative output end of the N$^{th}$ bidirectional DC/DC voltage conversion module (12) is connected with one end of the circuit switch (15), the other end of the circuit switch (15) is connected to a positive electrode of the primary bus (16);

the N battery packs (11) are connected in parallel with input ends of the N bidirectional DC/DC voltage conversion modules (12), a positive end of the first battery pack (11) is connected with a positive input end of the first bidirectional DC/DC voltage conversion module (12), and a negative end of the first battery pack (11) is connected with a negative input end of the first bidirectional DC/DC voltage conversion module (12), a positive end of the N$^{th}$ battery pack(11) is connected with a positive input end of the N$^{th}$ bidirectional DC/DC voltage conversion module(12), and a negative end of the N$^{th}$ battery pack (11) is connected with a negative input end of the N$^{th}$ bidirectional DC/DC voltage conversion module (12);

the N bypass switches (14) are connected in parallel with output ends of the N bidirectional DC/DC voltage conversion modules (12), one end of the first bypass switch (14) is connected with the negative output end of the first bidirectional DC/DC voltage conversion module (12), the other end of the first bypass switch (14) is connected with the positive output end of the first bidirectional DC/DC voltage conversion module (12), one end of the N$^{th}$ bypass switch (14) is connected with the negative output end of the N$^{th}$ bidirectional DC/DC voltage conversion module (12), and the other end of the N$^{th}$ bypass switch (14) is connected with the positive output end of the N$^{th}$ bidirectional DC/DC voltage conversion module (12);

the bidirectional DC/DC voltage conversion module (12) integrates functions of the battery management unit BMU (13) which can calculate a state of charge, estimate a health status, and manage safety of the battery pack (11) for the battery pack (11), and the bidirectional DC/DC voltage conversion modules (12) regulate its output voltage according to instructions of the BDCM coordination controller units (13);

the BDCM coordination controller units (13) manage the battery cluster, having functions of charging and discharging management of the battery cluster, calculation of the state of charge of the battery cluster, safety management of the battery cluster, controlling the bypass switches (14) to close or open, and controlling the circuit switches (15) to close or open, and having a function of communicating and information interaction with the outside;

the control method of battery cluster comprises calculating a total target voltage of the battery cluster, starting a process control, and stopping the process control;

a key algorithm for calculating the total target voltage of battery cluster is to determine the total target voltage of n$^{th}$ battery cluster V_target_cluster_n, V_target_cluster_n=V_max_cluster+V_con, where V_max_cluster is a maximum total voltage of battery cluster in all P battery cluster units (1);

n is a natural number from 1 to P; V_con is a fixed limit value, and the value of V_con satisfies: V_con≤V_DC_sum-V_max_cluster, where V_DC_sum is a sum of the output voltage limit values of all the DC/DC voltage conversion modules (12) in the battery cluster which has the maximum total voltage among all the battery clusters;

a key algorithm of the starting the process control is to determine the output voltage of the bidirectional DC/DC voltage conversion module (12), when a status consistency of all fault-free battery packs in the n$^{th}$ battery cluster is good, all bidirectional DC/DC voltage conversion modules of the n$^{th}$ battery cluster have an output voltage V_out_n=V_target_cluster_n/m, m is the number of all fault-free battery packs in the n$^{th}$ battery cluster; and when the status consistency of all fault-free battery packs in the n$^{th}$ battery cluster is poor, the k$^{th}$ bidirectional DC/DC voltage conversion module (12) in the n$^{th}$ battery cluster has a discharge output voltage

$$V\_dis\_out\_nk = V\_target\_cluster\_n \times SOC_{nk} / \sum_{i=1}^{m} SOC_{ni}$$

, and the k$^{th}$ bidirectional DC/DC voltage conversion module (12) in the n$^{th}$ battery cluster has a charging output voltage

$$V\_ch\_out\_nk = V\_target\_cluster\_n \times (1\text{-}SOC_{nk}) / \left( m - \sum_{i=1}^{m} SOC_{ni} \right)$$

, where SOC$_{nk}$ is a charge ratio of the k$^{th}$ battery pack (11) of the n$^{th}$ battery cluster, and m is the number of all fault-free battery packs of the n$^{th}$ battery cluster, and $\sum_{i=1}^{m} SOC_{ni}$ represents a sum of the charge ratios of all m fault-free battery packs in the n$^{th}$ battery cluster;

**characterized in that**, the step of calculating the total target voltage of battery cluster in the control method of battery cluster is as follows:

Step 1, the n$^{th}$ BDCM coordination controller unit (13) reads current voltages of all N battery packs (11) in the n$^{th}$ battery cluster unit (1), and adds voltages of the N battery pack (11) to obtain the total voltage V_total_n of the n$^{th}$ battery cluster unit(1), n being a natural number from 1 to P;

Step 2, each BDCM coordination controller unit (13) broadcasts the total voltage of a corresponding battery cluster unit (1) on its communication bus, each BDCM coordination controller unit (13) compares the total voltage of the battery cluster unit (1) of this battery cluster unit (1) with those of the battery cluster units (1) among other battery cluster units (1), and each BDCM coordination controller unit (13) broadcasts the maximum value of total voltage of the battery cluster in the battery cluster unit (1) determined by itself on its communication bus; and

Step 3, each BDCM coordination controller unit (13) receives the maximum value of the total voltage of the battery cluster broadcast on the communication bus, and compares these results with the maximum value of the total voltage of the battery cluster determined by itself, if the results are different, then it returns to the step 1 and calculates again; or if the results are the same, then it calculates the total target voltage of the battery cluster, the total target voltage of $n^{th}$ battery cluster is_target_cluster_n, V_target_cluster_n=V_max_cluster+V_con, where the V_max_cluster is the maximum value of the total voltage of the battery clusters in all P battery cluster units (1), n is a natural number from 1 to P, V_con is a fixed limit value, and the value of V_con satisfies: V_con≤V_DC_sum- V_max_cluster, where V_DC_sum is a sum of the limit values of the output voltages of all bidirectional DC/DC voltage conversion modules (12) in the battery cluster which has a maximum value of the total voltage of the battery cluster.

2. The control method of battery cluster for a lithium-ion battery energy storage system according to claim 1, **characterized in that**, the step of starting process control in the control method of battery cluster is as follows:

Step 1, the $n^{th}$ BDCM coordination controller unit (13) reads information of the battery pack (11) and the bidirectional DC/DC voltage conversion module (12) of the $n^{th}$ battery cluster unit (1), comprising the state of charge of the battery pack (11), the voltage of the battery pack (11), temperature of the battery pack (11), and fault information of the bidirectional DC/DC voltage conversion module (12);

Step 2, the $n^{th}$ BDCM coordination controller unit (13) determines consistency of the status of all N battery packs (11) in the $n^{th}$ battery cluster unit(1);

Step 3, if the consistency of the battery pack status of the $n^{th}$ battery cluster unit (1) meets requirements, the $n^{th}$ BDCM coordination controller unit (13) broadcasts the output voltage V_out_n of all bidirectional DC/DC voltage conversion modules (12) of the $n^{th}$ battery cluster on the communication bus, and V_out_n=V_target_cluster_n/m, m is the number of all fault-free battery packs (11) in the $n^{th}$ battery cluster; if the consistency of the battery pack status of the $n^{th}$ battery cluster unit (1) does not meet the requirements, then the $k^{th}$ bidirectional DC/DC voltage conversion module (12) of the $n^{th}$ battery cluster has a discharge output voltage

$$V\_dis\_out\_nk=V\_target\_cluster\_n \times SOC_{nk}/\sum_{i=1}^{m} SOC_{ni}$$

, the $k^{th}$ bidirectional DC/DC voltage conversion module (12) of the $n^{th}$ battery cluster has a charging output voltage

$$V\_ch\_out\_nk=V\_target\_cluster\_n \times (1\text{-}SOC_{nk}) / (m - \sum_{i=1}^{m} SOC_{ni})$$

, where $SOC_{nk}$ is the charge ratio of the $k^{th}$ battery pack (11) of the $n^{th}$ battery cluster, and m is the number of all fault-free battery packs (11) of the $n^{th}$ battery cluster, $\sum_{i=1}^{m} SOC_{ni}$ represents the sum of the charge ratios of all m fault-free battery packs (11) in the $n^{th}$ battery cluster, obviously, m ≤ P;

Step 4, if the output voltage of b bidirectional DC/DC voltage conversion modules (12) in the $n^{th}$ battery cluster exceeds a limit value (assuming the limit value is V_out_limit), the $n^{th}$ BDCM coordination controller unit (13) controls the output voltage of the bidirectional DC/DC voltage conversion module (12) to be V_out_limit, all other bidirectional DC/DC voltage conversion modules (12) in the $n^{th}$ battery cluster have an output voltage V_out_n=(V_target_cluster_n-V_out_limit)÷(m-b), where m is the number of all fault-free battery packs (11) in the $n^{th}$ battery cluster, and b is a natural number from 1 to m; and

Step 5, the $n^{th}$ BDCM coordination controller unit (13) determines whether the total voltage of the $n^{th}$ battery cluster unit (1) reaches the total target voltage V_target_cluster_n of the $n^{th}$ battery cluster or not, if not, it returns to the step 1, if it does, it proceeds to the charging or discharging phase;

in the above steps 1 to 5, n is a natural number from 1 to P, and P is the number of battery clusters.

3. The control method of battery cluster for a lithium-ion battery energy storage system according to claim 1, **characterized in that**, the step of stopping the process control in the control method of battery cluster is as follows:

Step 1, if the $n^{th}$ BDCM coordination controller unit (13) detects that the $r^{th}$ battery pack (11) of the $n^{th}$ battery cluster unit (1) fails, or the $r^{th}$ battery pack (11) reaches the charge cut-off condition, or the $r^{th}$ battery pack (11) reaches the discharge cut-off condition, or the $r^{th}$ bidirectional DC/DC voltage conversion module (12) fails, it proceeds to the next step;

Step 2, the $n^{th}$ BDCM coordination controller unit (13) controls the output voltage of the $r^{th}$ bidirectional DC/DC voltage conversion module (12) of the $n^{th}$ battery cluster unit (1) to be zero;

Step 3, the $n^{th}$ BDCM coordination controller unit (13) controls the bypass switch (14) in the $n^{th}$ battery cluster unit (1) that is connected in parallel with the $r^{th}$ bidirectional DC/DC voltage conversion module (12) to close;

Step 4: the $n^{th}$ BDCM coordination controller unit (13) controls the $r^{th}$ bidirectional DC/DC voltage conversion modules (12) of the $n^{th}$ battery cluster unit (1) to turn off the output; and

Step 5, the method returns to the step of calculating the total target voltage of the battery cluster, and then performs the step of starting the process control; if the total voltage of the battery cluster unit (1) does not reach the total target voltage of the battery cluster, or the battery cluster unit (1) has overcurrent protection, then the battery cluster unit (1) stops operating.

4. The control method of battery cluster for a lithium-ion battery energy storage system according to any of claims 1-3, **characterized in that**, the bypass switch functions as a bypass bidirectional DC/DC voltage conversion module (12); the battery pack (11) consists of two or more single lithium-ion batteries connected in series; the BDCM coordination controller unit (13) is connected with the bidirectional DC/DC voltage conversion module (12), the bypass switch (14), and the circuit switch (15) through the communication bus, and the battery management unit BMU of the bidirectional DC/DC voltage conversion module (12) is communicatively connected with an underlying management unit of the battery pack(11).

**Patentansprüche**

1. Ein Steuerungsverfahren für einen Batteriecluster eines Lithium-Ionen-Batteriespeichersystems, wobei die Batterieclustertopologie des Lithium-Ionen-Batteriespeichersystems P parallele Batterieclustereinheiten umfasst, wobei jede Batterieclustereinheit (1) aus N Batteriepacks (11), N bidirektionalen DC/DC-Spannungswandlermodulen (12), N Bypass-Schaltern (14), BDCM-Koordinationssteuereinheiten (13), Leitungsschaltern (15) und Primärbussen (16) für den Anschluss besteht, wobei P eine natürliche Zahl größer oder gleich 2 und N eine natürliche Zahl größer oder gleich 2 ist;

ausgangsenden der N bidirektionalen DC/DC-Spannungsumwandlungsmodule (12) sind in Reihe geschaltet, ein negatives Ausgangsende des ersten bidirektionalen DC/DC-Spannungsumwandlungsmoduls (12) ist mit einer negativen Elektrode des Primärbusses (16) verbunden, ein positives Ausgangsende des ersten bidirektionalen DC/DC-Spannungsumwandlungsmoduls (12) ist mit einem negativen Ausgangsende des zweiten bidirektionalen DC/DC-Spannungsumwandlungsmoduls (12) verbunden, ein positives Ausgangsende des zweiten bidirektionalen DC/DC-Spannungsumwandlungsmoduls (12) ist mit einem negativen Ausgangsende des dritten bidirektionalen DC/DC-Spannungsumwandlungsmoduls (12) verbunden, ein positives Ausgangsende eines (N-1) bidirektionalen DC/DC-Spannungsumwandlungsmoduls (12) ist mit einem negativen Ausgangsende der N-ten bidirektionalen DC/DC-Spannungsumwandlungsmodule (12) verbunden, und ein negatives Ausgangsende der N-ten bidirektionalen DC/DC-Spannungsumwandlungsmodule (12) ist mit einem Ende des Schaltungsschalters (15) verbunden, das andere Ende des Schaltungsschalters (15) ist mit einer positiven Elektrode des Primärbusses (16) verbunden;

die N-Batteriepakete (11) sind parallel mit den Eingangsanschlüssen der N bidirektionalen DC/DC-Spannungswandlermodule (12) verbunden, wobei ein positiver Anschluss des ersten Batteriepakets (11) mit einem positiven Eingangsanschluss des ersten bidirektionalen DC/DC-Spannungswandlermoduls (12) und ein negativer Anschluss des ersten Batteriepakets (11) mit einem negativen Eingangsanschluss des ersten bidirektionalen DC/DC-Spannungswandlermoduls (12) verbunden sind, wobei ein positiver Anschluss des N-ten Batteriepakets (11) mit einem positiven Eingangsanschluss des N-ten bidirektionalen DC/DC-Spannungswandlermoduls (12) und ein negativer Anschluss des N-ten Batteriepakets (11) mit einem negativen Eingangsanschluss des N-ten bidirektionalen DC/DC-Spannungswandlermoduls (12) verbunden ist;

die N Bypass-Schalter (14) sind parallel zu den Ausgängen der N bidirektionalen DC/DC-Spannungswandlermodule (12) geschaltet. Ein Ende des ersten Bypass-Schalters (14) ist mit dem negativen Ausgang des ersten bidirektionalen DC/DC-Spannungswandlermoduls (12) verbunden. Das andere Ende des ersten Bypass-Schalters (14) ist mit dem positiven Ausgang des ersten bidirektionalen DC/DC-Spannungswandlermoduls (12) verbunden. Ein Ende des N-ten Bypass-Schalters (14) ist mit dem negativen Ausgang des N-ten bidirektionalen DC/DC-Spannungswandlermoduls (12) verbunden. Das andere Ende des N-ten Bypass-Schalters (14) ist mit dem positiven Ausgang des N-ten bidirektionalen DC/DC-Spannungswandlermoduls (12) verbunden;

das bidirektionale DC/DC-Spannungswandlermodul (12) integriert Funktionen der Batteriemanagementeinheit (BMU) (13), die den Ladezustand berechnen, den Zustand einschätzen und die Sicherheit des Batteriepacks (11) verwalten kann. Die bidirektionalen DC/DC-Spannungswandlermodule (12) regeln die Ausgangsspannung gemäß den Anweisungen der BDCM-Koordinationssteuereinheiten (13);

die BDCM-Koordinationssteuereinheiten (13) verwalten den Batteriecluster und übernehmen Funktionen wie Lade- und Entlademanagement, Berechnung des Ladezustands, Sicherheitsmanagement, Steuerung der Bypass-Schalter (14) zum Schließen und Öffnen und Steuerung der Stromkreisschalter (15) zum Schließen und Öffnen. Zudem verfügen sie über eine Funktion zur Kommunikation und Informationsinteraktion mit der Außenwelt;

das Steuerungsverfahren des Bat</clusters umfasst die Berechnung der Gesamtzielspannung des Batterieclusters, das Starten und Stoppen einer Prozesssteuerung;

ein Schlüsselalgorithmus zur Berechnung der Gesamtzielspannung eines Batterieclusters besteht darin, die Gesamtzielspannung von N-ten Batterieclustern zu bestimmen: V_max_cluster n V_max_cluster n=V_max_cluster+V_con, wobei V_max_cluster die maximale Gesamtspannung des Batterieclusters in allen P Batterieclustereinheiten (1) ist;

n eine natürliche Zahl zwischen 1 und P ist; V_con ein fester Grenzwert ist und der Wert von V_con die Bedingung V_con≤V_max_cluster erfüllt, wobei V_con die Summe der Ausgangsspannungsgrenzwerte aller DC/DC-Spannungswandlermodule (12) im Batteriecluster mit der maximalen Gesamtspannung aller Batteriecluster ist;

ein Schlüsselalgorithmus der Startprozesssteuerung besteht darin, die Ausgangsspannung des bidirektionalen DC/DC-Spannungsumwandlungsmoduls (12) zu bestimmen. Wenn eine Statuskonsistenz aller fehlerfreie N-Batteriepakete im N-ten Batteriecluster gut ist, weisen alle bidirektionalen DC/DC-Spannungsumwandlungsmodule des N-ten Batterieclusters eine Ausgangsspannung von V_out_n=V_target_c1uster_n/m auf, wobei m die Anzahl aller fehlerfreie N-Batteriepakete im N-ten Batteriecluster ist; und wenn die Statuskonsistenz aller fehlerfreie N-Batteriepakete im N-ten Batteriecluster schlecht ist, hat das k-te bidirektionale DC/DC-Spannungsumwandlungsmodul (12) im N-ten Batteriecluster eine Entladeausgangsspannung

$$V\_dis\_out\_nk = V\_target\_cluster\_n \times SOC_{nk} / \sum_{i=1}^{m} SOC_{ni}$$

und das k-te bidirektionale DC/DC-Spannungsumwandlungsmodul (12) im N-ten Batteriecluster hat eine Ladeausgangsspannung

$$V\_ch\_out\_nk = V\_target\_cluster\_n \times (1 - SOC_{nk})/(m - \sum_{i=1}^{m} SOC_{ni})$$

, wobei SOC$_{nk}$ ein Ladeverhältnis des k-ten Batteriepakets (11) des N-ten Batterieclusters ist und m die Anzahl aller fehlerfreie N-Batteriepakete des N-ten Batterieclusters ist und

$$\sum_{i=1}^{m} SOC_{ni'}$$

eine Summe der Ladeverhältnisse aller m fehlerfreie N-Batteriepakete im N-ten Batteriecluster darstellt;

**dadurch gekennzeichnet, dass** der Schritt des Berechnens der Gesamtzielspannung des Batterieclusters im Steuerungsverfahren des Batterieclusters wie folgt ist:

Schritt 1, die N-ten BDCM-Koordinationssteuereinheit (13) liest die aktuellen Spannungen aller N-Batteriepakete (11) in der N-ten Batterieclustereinheit (1) und addiert die Spannungen der N-Batteriepakete (11), um die Gesamtspannung V_total_n der N-ten Batterieclustereinheit (1) zu erhalten, wobei n eine natürliche Zahl zwischen 1 und P ist.

Schritt 2, jede BDCM-Koordinationssteuereinheit (13) sendet die Gesamtspannung einer entsprechenden Batterieclustereinheit (1) über ihren Kommunikationsbus. Jede BDCM-Koordinationssteuereinheit (13) vergleicht die Gesamtspannung der Batterieclustereinheit (1) dieser Batterieclustereinheit (1) mit denen der Batterieclustereinheiten (1) unter anderen Batterieclustereinheiten (1) und sendet den von ihr selbst ermittelten Maximalwert der Gesamtspannung des Batterieclusters in der Batterieclustereinheit (1) über ihren Kommunikationsbus.

Schritt 3, jede BDCM-Koordinationssteuereinheit (13) empfängt den über den Kommunikationsbus gesendeten Maximalwert der Gesamtspannung des Batterieclusters und vergleicht diese Ergebnisse mit dem von ihr selbst ermittelten Maximalwert der Gesamtspannung des Batterieclusters. Weichen die Ergebnisse voneinander ab, kehrt sie zu Schritt 1 zurück und berechnet erneut; sind die Ergebnisse gleich, berechnet sie die Gesamtzielspannung des Batterieclusters. Die Gesamtzielspannung von N-ten Batterieclustern ist Zielcluster n, V_target_cluster=V_max_cluster+V_con, wobei V_max_cluster der Maximalwert der Gesamtspannung der Batteriecluster in allen P Batterieclustereinheiten (1) ist, n eine natürliche Zahl von 1 bis P ist, V_con ein fester Grenzwert ist und der Wert von V_con die Gleichung V_con≤V_DC_sum-V_max_cluster erfüllt, wobei V DC Summe die Summe der Grenzwerte der Ausgangsspannungen aller bidirektionalen DC/DC-Spannungswandlermodule (12) im Batteriecluster ist, der den Maximalwert der Gesamtspannung

des Batfliericlusters aufweist.

2. Steuerungsverfahren für einen Batteriecluster für ein Lithium-Ionen-Batterie-Energiespeichersystem nach Anspruch 1, **dadurch gekennzeichnet, dass** der Schritt des Startens der Prozesssteuerung im Steuerungsverfahren für den Batteriecluster wie folgt abläuft:

Schritt 1, die N-ten BDCM-Koordinationssteuereinheit (13) liest Informationen des Batteriepacks (11) und des bidirektionalen DC/DC-Spannungswandlermoduls (12) der N-ten Batterieclustereinheit (1) aus, darunter Ladezustand, Spannung und Temperatur des Batteriepacks (11) sowie Fehlerinformationen des bidirektionalen DC/DC-Spannungswandlermoduls (12);

Schritt 2, die N-ten BDCM-Koordinationssteuereinheit (13) ermittelt die Statuskonsistenz aller N Batteriepacks (11) in der N-ten Batterieclustereinheit (1);

Schritt 3, wenn die Konsistenz des Batteriepackstatus der N-ten Batterieclustereinheit (1) die Anforderungen erfüllt, überträgt die N-ten BDCM-Koordinationscontrollereinheit (13) die Ausgangsspannung V_out n aller bidirektionalen DC/DC-Spannungsumwandlungsmodule (12) des N-ten Batterieclusters auf dem Kommunikationsbus, und V_out_n= V_target_cluster_n/m, m ist die Anzahl aller fehlerfreien Batteriepacks (11) im N-ten Batteriecluster; Wenn die Konsistenz des Batteriepackstatus der N-ten Batterieclustereinheit (1) nicht den Anforderungen entspricht, weist das k-ten bidirektionale DC/DC-Spannungswandlermodul (12) des N-ten Batterieclusters eine Entladeausgangsspannung von

$$V\_dis\_out\_nk = V\_target\_cluster\_n \times SOC_{nk} / \sum_{i=1}^{m} SOC_{ni}$$

. Das k-ten bidirektionale DC/DC-Spannungswandlermodul (12) des N-ten Batterieclusters weist eine Ladeausgangsspannung von

$$V\_ch\_out\_nk = V\_target\_cluster\_n \times (1 - SOC_{nk})/(m - \sum_{i=1}^{m} SOC_{ni})$$

, auf. Dabei ist $SOC_{nk}$ der Lade-zustand des k-ten Batteriepacks (11) des N-ten Batterieclusters und m die Anzahl aller fehlerfreien Batteriepacks (11) des N-ten Batterieclusters. $\sum_{i=1}^{m} SOC_{ni}$ stellt die Summe der Ladezustände aller m fehlerfreien Batteriepacks (11) im N-ten Batteriecluster dar, offensichtlich m ≤ P;

Schritt 4, wenn die Ausgangsspannung von b bidirektionalen DC/DC-Spannungswandlermodulen (12) im N-ten Batteriecluster überschreitet einen Grenzwert (angenommen, der Grenzwert ist V_out limit), regelt die N-ten BDCM-Koordinationssteuereinheit (13) die Ausgangsspannung des bidirektionalen DC/DC-Spannungswandlermoduls (12) auf V_out limit. Alle anderen bidirektionalen DC/DC-Spannungswandlermodule (12) im N-ten Batteriecluster haben eine Ausgangsspannung von V_out_n = (V_out cluster n - V_out limit) + (m - b), wobei m die Anzahl aller fehlerfreien Batteriepacks (11) im N-ten Batteriecluster und b eine natürliche Zahl zwischen 1 bis m ist; und

Schritt 5, die N-ten BDCM-Koordinationssteuereinheit (13) ermittelt, ob die Gesamtspannung der N-ten Batterieclustereinheit (1) die Gesamtzielspannung V_out_cluster_n des N-ten Batterieclusters erreicht. Ist dies nicht der Fall, kehrt sie zu Schritt 1 zurück. Ist dies der Fall, fährt sie mit der Lade- oder Entladephase fort;

in den obigen Schritten 1 bis 5, n ist eine natürliche Zahl von 1 bis P und P ist die Anzahl der Batteriecluster.

3. Steuerungsverfahren für einen Batteriecluster für ein Lithium-Ionen-Batterie-Energiespeichersystem nach Anspruch 1, **dadurch gekennzeichnet, dass** der Schritt des Stoppens der Prozesssteuerung im Steuerungsverfahren für den Batteriecluster wie folgt abläuft:

Schritt 1: Wenn die N-ten BDCM-Koordinationssteuereinheit (13) erkennt, dass der Ph-Batteriepack (11) der N-ten-Batterieclustereinheit (1) ausfällt, der r-te-Batteriepack (11) den Lade-Abschaltzustand erreicht, der r-te-Batteriepack (11) den Entlade-Abschaltzustand erreicht oder das r-ten-bidirektionale DC/DC-Spannungswandlermodul (12) ausfällt, fährt sie mit dem nächsten Schritt fort;

Schritt 2; die N-ten BDCM-Koordinationssteuereinheit (13) regelt die Ausgangsspannung des r-tenbidirektionalen DC/DC-Spannungswandlermoduls (12) der N-ten-Batterieclustereinheit (1) auf Null;

Schritt 3; die N-ten BDCM-Koordinationssteuereinheit (13) steuert den Bypass-Schalter (14) in der N-ten Batterieclustereinheit (1), die parallel zum r-ten bidirektionalen DC/DC-Spannungswandlermodul (12) geschaltet ist, zum Schließen an.

Schritt 4; die N-ten BDCM-Koordinationssteuereinheit (13) steuert die r-ten bidirektionalen DC/DC-Spannungswandlermodule (12) der N-ten Batterieclustereinheit (1) zum Abschalten des Ausgangs;

Schritt 5; das Verfahren kehrt zum Schritt der Berechnung der Gesamtzielspannung des Batterieclusters zurück und führt anschließend den Schritt des Startens der Prozesssteuerung aus. Erreicht die Gesamtspannung der Batterieclustereinheit (1) die Gesamtzielspannung nicht oder ist die Batterieclustereinheit (1) mit einem Überstromschutz ausgestattet, stoppt die Batterieclustereinheit (1) den Betrieb.

4. Steuerungsverfahren für einen Batteriecluster für ein Lithium-Ionen-Batterie-Energiespeichersystem gemäß einem der Ansprüche 1-3, **dadurch gekennzeichnet, dass** der Bypass-Schalter als bidirektionales Bypass-DC/DC-Spannungswandlermodul (12) fungiert; der Batteriepack (11) aus zwei oder mehr in Reihe geschalteten einzelnen Lithium-Ionen-Batterien besteht; die BDCM-Koordinationssteuereinheit (13) über den Kommunikationsbus mit dem bidirektionalen DC/DC-Spannungswandlermodul (12), dem Bypass-Schalter (14) und dem Stromkreisschalter (15) verbunden ist und die Batteriemanagementeinheit BMU des bidirektionalen DC/DC-Spannungswandlermoduls (12) kommunikativ mit einer zugrunde liegenden Managementeinheit des Batteriepacks (11) verbunden ist.

**Revendications**

1. Un procédé de commande d'une grappe de batteries pour un système de stockage d'énergie à batterie lithium-ion, dans lequel une topologie de grappe de batteries pour le système de stockage d'énergie à batterie lithium-ion comprend P unités de grappe de batteries reliées en parallèle, chaque unité de grappe de batteries (1) étant composée de N modules de batterie (11), N modules bidirectionnels de conversion de tension DC/DC (12), N interrupteurs de dérivation (14), unités de commande de coordination BDCM (13), interrupteurs de circuit (15), et barres omnibus principales (16) pour la connexion, où P est un nombre entier naturel supérieur ou égal à 2, et N est un nombre entier naturel supérieur ou égal à 2;

les bornes de sorties des N modules bidirectionnels de conversion de tension DC/DC (12) sont reliées en série dans un ordre déterminé, la borne de sortie négative du premier module bidirectionnel de conversion de tension DC/DC (12) est reliée à l'électrode négative de la barre omnibus principale (16), et la borne de sortie positive du premier module bidirectionnel de conversion de tension DC/DC (12) est reliée à la borne de sortie négative du deuxième module bidirectionnel de conversion de tension DC/DC (12), la borne de sortie positive du deuxième module bidirectionnel de conversion de tension DC/DC (12) est reliée à la borne de sortie négative du troisième module bidirectionnel de conversion de tension DC/DC (12), et ainsi de suite, jusqu'à ce que la borne de sortie positive du $(N-1)^e$ module bidirectionnel de conversion de tension DC/DC (12) soit reliée à la borne de sortie négative du $N^e$ module bidirectionnel de conversion de tension DC/DC (12), et que la borne de sortie positive du $N^e$ module bidirectionnel de conversion de tension DC/DC (12) soit reliée à une extrémité de l'interrupteur de circuit (15), l'autre extrémité de l'interrupteur de circuit (15) étant reliée à l'électrode positive de la barre omnibus principale (16);
les N modules de batterie (11) sont connectés en parallèle aux entrées des N modules bidirectionnels de conversion de tension DC/DC (12), la borne positive du premier module de batterie (11) est reliée à l'entrée positive du premier module bidirectionnel de conversion de tension DC/DC (12), et la borne négative du premier module de batterie (11) est relié à l'entrée négative du premier module bidirectionnel de conversion de tension DC/DC (12), la borne positive du $N^e$ module de batterie (11) est relié à l'entrée positive du $N^e$ module bidirectionnel de conversion de tension DC/DC (12), et sa borne négative à l'entrée négative du $N^e$ module bidirectionnel de conversion de tension DC/DC (12);
les N interrupteurs de dérivation (14) sont connectés en parallèle aux sorties des N modules bidirectionnels de conversion de tension DC/DC (12), une extrémité du premier interrupteur de dérivation (14) est reliée à la sortie négative du premier module bidirectionnel de conversion de tension DC/DC (12), l'autre extrémité du premier interrupteur de dérivation (14) est reliée à la sortie positive du premier module bidirectionnel de conversion de tension DC/DC (12), une extrémité du $N^e$ interrupteur de dérivation (14) est reliée à la sortie négative du $N^e$ module bidirectionnel de conversion de tension DC/DC (12), et l'autre extrémité du $N^e$ interrupteur de dérivation (14) est reliée à la sortie positive du $N^e$ module bidirectionnel de conversion de tension DC/DC (12).
le module bidirectionnel de conversion de tension DC/DC (12) intègre les fonctions de l'unité de gestion de batterie BMU (13), capable de calculer l'état de charge (SOC), d'estimer l'état de santé (SOH) et de gérer la sécurité du module de batterie (11), et le module bidirectionnel de conversion de tension DC/DC (12) régule sa tension de sortie selon les instructions des unités de commande de coordination BDCM (13);
les unités de commande de coordination BDCM (13) assurent la gestion de la grappe de batteries, comprenant la gestion des cycles de charge et de décharge de la grappe de batteries, le calcul de l'état de charge global de la grappe de batteries, la gestion de la sécurité de la grappe de batteries, le contrôle de l'ouverture et la fermeture des interrupteurs de dérivation (14) ainsi que des interrupteurs de circuit (15), et assurent les fonctions de communication et d'échanges d'informations avec l'extérieur;
le procédé de commande de la grappe de batteries comprend le calcul d'une tension cible totale de la grappe de batteries, le démarrage du processus de commande, et l'arrêt du processus de commande;

un algorithme clé pour le calcul de la tension cible totale d'une grappe de batteries consiste à déterminer la tension cible totale de la $n^e$ grappe de batteries, notée V_target_cluster_n,

V_target_cluster_n = V_max_cluster + V_con, où V_max_cluster représente la tension totale maximale parmi toutes les P unités de grappes de batteries (1) ;

n est un entier naturel compris entre 1 et P ; V_con est une valeur limite fixe, et la valeur de V_con satisfait la condition suivante : V_con ≤ V_DC_sum - V_max_cluster, où V_DC_sum désigne la somme des valeurs limites de tension de sortie de tous les modules bidirectionnels de conversion de tension DC/DC (12) de la grappe de batteries présentant la tension totale maximale parmi toutes les grappes de batteries.

un algorithme clé du démarrage de commande du contrôle consiste à déterminer la tension de sortie du module bidirectionnel de conversion de tension DC/DC (12), lorsque la cohérence d'état de tous les modules de batteries non défectueux de la $n^e$ grappe de batteries est satisfaisante, tous les modules bidirectionnels de conversion de tension DC/DC de la $n^e$ grappe de batteries délivrent une tension de sortie V_out_n = V_target_cluster_n / m, où m est le nombre total de modules de batteries non défectueux dans la $n^e$ grappe de batteries ; en revanche lorsque la cohérence d'état de tous les modules de batteries non défectueux de la $n^e$ grappe de batteries est faible, le $k^e$ module bidirectionnel de conversion de tension DC/DC (12) de la $n^e$ grappe de batteries présente une tension de sortie en décharge
$$V\_dis\_out\_nk = V\_target\_cluster\_n \times SOC_{nk} / \sum_{i=1}^{m} SOC_{ni}$$
; et le $k^e$ module bidirectionnel de conversion de tension DC/DC (12) de la $n^e$ grappe de batteries présente une tension de sortie en charge V_ch_out_nk = V_target_cluster_n $\times$ (1 - $\dfrac{SOC_{nk})/(m - \sum_{i=1}^{m} SOC_{ni})}{}$ , où $SOC_{nk}$ est le taux de charge du $k^e$ module de batteries (11) de la $n^e$ grappe de batteries, m est le nombre total de modules de batteries non défectueux de la $n^e$ grappe de batteries, et $\sum_{i=1}^{m} SOC_{ni}$ représente la somme des taux de charge des m modules de batteries non défectueux de la $n^e$ grappe de batteries.

le procédé de calcul de la tension cible totale d'une grappe de batteries dans la méthode de contrôle de grappe de batteries est **caractérisé en ce que** :

Étape 1: l'unité de commande de coordination BDCM $n^e$ (13) lit les tensions actuelles de tous les modules de batteries (11) de la $n^e$ unité de grappe de batteries (1), et additionne les tensions des N modules de batteries (11) afin d'obtenir la tension totale V_total_n de la $n^e$ unité de grappe de batteries (1), où n est un entier naturel compris entre 1 et P ;

Étape 2: chaque unité de commande de coordination BDCM (13) diffuse la tension totale de son unité de grappe de batteries (1) sur son bus de communication ; chaque unité de commande de coordination BDCM (13) compare la tension totale de sa propre grappe de batteries avec celles des autres unités de grappes de batteries (1), et chaque unité de commande de coordination BDCM (13) diffuse sur le bus de communication la valeur maximale de tension totale de grappe de batteries qu'elle a déterminée ; et

Étape 3: chaque unité de commande de coordination BDCM (13) reçoit la valeur maximale de la tension totale de grappe de batteries diffusée sur le bus de communication, et compare ces résultats avec la valeur maximale de tension totale qu'elle a elle-même déterminée ; si les résultats diffèrent, alors le processus revient à l'étape 1 pour recalcul ; si les résultats sont identiques, alors la tension cible totale de la grappe de batteries est calculée : la tension cible totale de la $n^e$ grappe de batteries est

$$V\_target\_cluster\_n = V\_max\_cluster + V\_con,$$

où V_max_cluster est la valeur maximale des tensions totales des grappes de batteries dans les P unités de grappes de batteries (1), n est un entier naturel compris entre 1 et P, V_con est une valeur limite fixe, et la valeur de V_con satisfait la condition suivante :

$$V\_con \leq V\_DC\_sum - V\_max\_cluster,$$

où V_DC_sum est la somme des valeurs limites de tension de sortie de tous les modules bidirectionnels de conversion de tension DC/DC (12) de la grappe de batteries présentant la tension totale maximale parmi toutes les grappes.

2. Procédé de contrôle de grappe de batteries pour un système de stockage d'énergie à batterie lithium-ion selon la revendication 1, **caractérisé en ce que** l'étape de contrôle du processus de démarrage dans ledit procédé de contrôle de grappe de batteries est la suivante :

Étape 1: l'unité de commande de coordination BDCM n$^e$ (13) lit les informations du module de batteries (11) et du module bidirectionnel de conversion de tension DC/DC (12) de la n$^e$ unité de grappe de batteries (1),

comprenant l'état de charge du module de batteries (11), la tension du module de batteries (11), la température du module de batteries (11),
et les informations de défaut du module bidirectionnel de conversion de tension DC/DC (12) ;

Étape 2: l'unité de commande de coordination BDCM n$^e$ (13) détermine la cohérence de l'état de l'ensemble des N modules de batteries (11) de la n$^e$ unité de grappe de batteries (1) ;

Étape 3 : si la cohérence de l'état des modules de batteries de la n$^e$ unité de grappe de batteries (1) est conforme aux exigences,

alors l'unité de commande de coordination BDCM n$^e$ (13) diffuse sur le bus de communication la tension de sortie V_out_n de tous les modules bidirectionnels de conversion de tension DC/DC (12) de la n$^e$ grappe de batteries, et V_out_n = V_target_cluster_n / m,
où m est le nombre de modules de batteries (11) non défectueux dans la n$^e$ grappe de batteries ;

- si la cohérence de l'état des modules de batteries de la n$^e$ unité de grappe de batteries (1) ne satisfait pas aux exigences, alors le module bidirectionnel de conversion de tension DC/DC (12) k de la n$^e$ grappe de batteries présente une tension de sortie en décharge

$$V\_dis\_out\_nk = V\_target\_cluster\_n \times SOC_{nk} / \sum_{i=1}^{m} SOC_{ni}$$

; et ce même module présente une tension de sortie en charge $V\_ch\_out\_nk$ =

$$V\_target\_cluster\_n \times (1 - SOC_{nk})/(m - \sum_{i=1}^{m} SOC_{ni})$$

, où SOCnk est le taux de charge du k$^e$ module de batteries (11) de la n$^e$ grappe de batteries, m est le nombre de modules de batteries (11) non défectueux dans la n$^e$ grappe,

et $\sum_{i=1}^{m} SOC_{ni}$ représente la somme des taux de charge des m modules de batteries non défectueux dans la n$^e$ grappe de batteries ;
évidemment, on a m $\leq$ P ;

Étape 4 : si la tension de sortie de b dans la n$^e$ grappe de batteries dépasse une valeur limite (cette valeur étant notée V_out_limit),

l'unité de commande de coordination BDCM n$^e$ (13) régule la tension de sortie des modules bidirectionnels de conversion de tension DC/DC (12) pour qu'elle soit égale à V_out _limit,
et la tension de sortie des autres modules bidirectionnels de conversion DC/DC (12) de la n$^e$ grappe est :

$$V\_out\_n = (V\_target\_cluster\_n - V\_out\_limit) \div (m - b),$$

où m est le nombre total de modules de batteries (11) non défectueux de la n$^e$ grappe de batteries,
et b est un entier naturel compris entre 1 et m ;

Étape 5: l'unité de commande de coordination BDCM n$^e$ (13) détermine si la tension totale de la n$^e$ unité de grappe de batteries (1) atteint la tension cible totale V_target_cluster_n de la n$^e$ grappe de batteries ;

- si ce n'est pas le cas, le processus retourne à l'étape 1 ;
- si oui, il passe à la phase de charge ou de décharge ;

dans les étapes ci-dessus (1 à 5), n est un entier naturel compris entre 1 et P, et P est le nombre total de grappes de batteries.

3. Procédé de contrôle de grappe de batteries pour un système de stockage d'énergie à batterie lithium-ion selon la revendication 1,
**caractérisé en ce que** l'étape de contrôle du processus d'arrêt dans ledit procédé de contrôle de grappe de batteries est la suivante :

Étape 1 : si l'unité de commande de coordination BDCM $n^e$ (13) détecte que le $r^e$ module de batteries (11) de la $n^e$ unité de grappe de batteries (1) est défectueux, ou que ce module de batteries atteint la condition de coupure en charge, ou qu'il atteint la condition de coupure en décharge,ou encore que le $r^e$ module bidirectionnel de conversion de tension DC/DC (12) est défectueux, alors le processus passe à l'étape suivante ;

Étape 2 : l'unité de commande de coordination BDCM $n^e$ (13) commande la tension de sortie du $r^e$ module bidirectionnel de conversion de tension DC/DC (12) de la $n^e$ unité de grappe de batteries (1) pour qu'elle soit nulle ;

Étape 3 : l'unité de commande de coordination BDCM $n^e$ (13) commande la fermeture de l'interrupteur de dérivation (14) de la $n^e$ grappe de batteries (1), lequel est connecté en parallèle avec le $r^e$ module bidirectionnel de conversion de tension DC/DC (12) ;

Étape 4 : l'unité de commande de coordination BDCM $n^e$ (13) désactive la sortie du $r^e$ module bidirectionnel de conversion de tension DC/DC (12) de la $n^e$ grappe de batteries (1) ; et

Étape 5 : le procédé revient à l'étape de calcul de la tension cible totale de la grappe de batteries, puis exécute l'étape de contrôle du processus de démarrage ; si la tension totale de l'unité de grappe de batteries (1) n'atteint pas la tension cible totale de la grappe de batteries, ou si l'unité de grappe de batteries (1) présente une protection contre les surintensités, alors ladite unité de grappe de batteries (1) cesse de fonctionner.

4. Procédé de contrôle de grappe de batteries pour un système de stockage d'énergie à batterie lithium-ion selon l'une quelconque des revendications 1 à 3, **caractérisé en ce que** : l'interrupteur de dérivation (14) fonctionne en tant que module bidirectionnel de conversion de tension DC/DC (12) de dérivation ; le module de batteries (11) est constitué de deux ou plusieurs cellules lithium-ion unitaires reliées en série ; l'unité de commande de coordination BDCM (13) est reliée, via le bus de communication, au module bidirectionnel de conversion de tension DC/DC (12), à l'interrupteur de dérivation (14) et à l'interrupteur de circuit (15) ; l'unité de gestion de batterie (BMU) du module bidirectionnel de conversion de tension DC/DC (12) est reliée en communication avec une unité de gestion de bas niveau du module de batteries (11).

FIG. 1

The first battery cluster unit

BDCM coordination controller unit 1

$K_{11}$

$K_{12}$

···

$K_{1(N-1)}$

$K_{1N}$

DCDC output

DCDC input

BMU

Battery pack 1

DCDC output

DCDC input

BMU

Battery pack 2

DCDC output

DCDC input

BMU

Battery pack N-1

DCDC output

DCDC input

BMU

Battery pack N

$K_1$

DC BUS

The second battery cluster unit

BDCM coordination controller unit 2

$K_{21}$

$K_{22}$

···

$K_{2(N-1)}$

$K_{2N}$

DCDC output

DCDC input

BMU

Battery pack 1

DCDC output

DCDC input

BMU

Battery pack 2

DCDC output

DCDC input

BMU

Battery pack N-1

DCDC output

DCDC input

BMU

Battery pack N

$K_2$

······

The $p^{th}$ battery cluster unit

BDCM coordination controller unit P

$K_{P1}$

$K_{P2}$

···

$K_{P(N-1)}$

$K_{PN}$

DCDC output

DCDC input

BMU

Battery pack 1

DCDC output

DCDC input

BMU

Battery pack 2

DCDC output

DCDC input

BMU

Battery pack N-1

DCDC output

DCDC input

BMU

Battery pack N

$K_P$

**FIG. 2**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20200177018 A1